## Europäisches Patentamt
## European Patent Office
## Office européen des brevets

(19)

(11) Veröffentlichungsnummer: **0 074 687**
**B1**

(12) # EUROPÄISCHE PATENTSCHRIFT

(45) Veröffentlichungstag der Patentschrift:
**20.07.88**

(51) Int. Cl.⁴: **H 03 B 5/18**

(21) Anmeldenummer: **82201116.9**

(22) Anmeldetag: **09.09.82**

(54) **Mikrowellen-Oszillator in Gegentaktschaltung.**

(30) Priorität: **14.09.81 DE 3136348**

(43) Veröffentlichungstag der Anmeldung:
**23.03.83 Patentblatt 83/12**

(45) Bekanntmachung des Hinweises auf die Patenterteilung:
**20.07.88 Patentblatt 88/29**

(84) Benannte Vertragsstaaten:
**DE FR GB IT SE**

(56) Entgegenhaltungen:
**FR-A-2 236 326**

**NACHRICHTENTECHNISCHE ZEITSCHRIFT, Band 27, Nr. 5, 1974, Seiten 196-197, Berlin, DE; C. HAMILTON: "Transistor harmonic oscillators with outputs in X-band"**
**1980 IEEE MTT-S INTERNATIONAL MICROWAVE SYMPOSIUM DIGEST, Seiten 499-500, IEEE, New York, US; R.G. WINCH u.a.: "Very linear X-band MIC bipolar VCO with 100MHz FM rate"**

(73) Patentinhaber: **Philips Patentverwaltung GmbH, Wendenstrasse 35 Postfach 10 51 49, D-2000 Hamburg 1 (DE)**

(84) Benannte Vertragsstaaten: **DE**

(73) Patentinhaber: **N.V. Philips' Gloeilampenfabrieken, Groenewoudseweg 1, NL- 5621 BA Eindhoven (NL)**

(84) Benannte Vertragsstaaten: **FR GB IT SE**

(72) Erfinder: **Lütteke, Georg, Franziskusweg 6, D-5100 Aachen (DE)**

(74) Vertreter: **Hartmann, Heinrich, Dipl.- Ing., Philips Patentverwaltung GmbH Wendenstrasse 35 Postfach 10 51 49, D-2000 Hamburg 1 (DE)**

EP 0 074 687 B1

LIBER, STOCKHOLM 1988

## Beschreibung

Die Erfindung bezieht sich auf einen Mikrowellen-Oszillator in Gegentaktschaltung mit zwei Transistoren, bei dem an einem Symmetriepunkt der Grundschwingung die Schwingungen der zweiten Harmonischen (der doppelten Frequenz der Grundschwingung) entnommen werden.

Einer derartigen Schaltung, die aus der DE-B-23 34 570, Fig. 6 und 7, bekannt ist, liegt ein Prinzipschaltbild nach Fig. 1 zugrunde. Die Schaltung ist mit zwei npn-Transistoren 1 und 2 symmetrisch aufgebaut, deren Kollektoren an Masse liegen. Zwischen den Basen der Transistoren 1 und 2 liegt die Reihenschaltung je eines, vorzugsweise einstellbaren, Kondensators 3 bzw. 4 und einer Induktivität 5 bzw. 6, mit deren Hilfe die Schaltung auf die Grundschwingung abgestimmt ist. Der Symmetriepunkt M der Reihenimpedanz 3, 4, 5, 6 liegt für die Grundschwingungen auf Masse; am Punkt M ist, ggf. über einen Wellenleiter, ein Belastungswiderstand 7 für die Oberschwingungen angeschlossen.

Zwischen Emitter und Kollektor der Transistoren 1 und 2 liegen Kondensatoren 9 bzw. 10, mit denen die Rückkopplung dieser Transistoren eingestellt ist. Für die Rückkopplung und die Abstimmung sind noch innere Kapazitäten und Streukapazitäten wirksam, die in das gesamte Netzwerk eingehen und im einzelnen nicht näher angegeben sind. Weiter sind noch Belastungen (Dämpfungen) für die Grundschwingung wirksam, die jedoch möglichst gering gehalten werden sollen, um eine starke Aussteuerung und damit eine entsprechend hohe Oberschwingungsausbeute zu ermöglichen.

Wenn die Frequenz eines solchen Oszillators genau konstant gehalten werden soll, kann in bekannter Weise die Phase gegenüber einer Bezugsschwingung verglichen und geregelt werden. Die Bezugsschwingung hat üblicherweise eine niedrigere Frequenz, weil diese gegenüber äußeren Einflüssen, z. B. Änderungen der Speisespannung oder der Temperatur, besser konstant gehalten werden kann und weil sie leichter über eine Übertragungsstrecke zugeführt werden kann. Um demgegenüber die Mikrowellen-Schwingungen zu vergleichen, müssen sie in der Frequenz geteilt werden. Teiler für hohe Frequenzen, z. B. über 1,5 GHz, sind schwierig zu realisieren. Der Erfindung liegt der Gedanke zugrunde, daß ein Oberschwingungsoszillator schon eine Frequenzreduktion bezüglich der abgegebenen Oberschwingung enthält, so daß z. B. zwischen der zweiten Harmonischen und der Grundschwingung eine Frequenzteilung im Verhältnis 2 : 1 besteht.

Der Erfindung liegt daher die Aufgabe zugrunde, einem Oberschwingungsoszillator einen kleinen Teil der Grundschwingung zu entnehmen. Mit dieser Grundschwingungsenergie kann dann ein weiterer Frequenzteiler angesteuert werden. Die Entnahme der Grundschwingungsenergie soll dabei so erfolgen, daß die Reduzierung der Oberschwingungsamplitude, z. B. durch verminderte Aussteuerung des aktiven Elementes durch die Grundschwingung, möglichst gering ist, wobei weiter am Entnahmepunkt die Amplitude der Grundschwingung groß gegenüber der Amplitude der Oberschwingung sein soll.

Bei einem Oszillator der eingangs erwähnten Art wird diese Aufgabe gemäß der Erfindung dadurch gelöst, daß an der Basiselektrode wenigstens eines Transistors über eine kapazitive Impedanz ein Teil der Grundschwingungen entnommen wird, wodurch die Belastung des Oszillators für die Grundwelle gering gehalten wird und eine hohe Oberschwingungsausbeute gewährleistet bleibt.

Nach einer bevorzugten Ausführungsform der Erfindung sind bei in den Kollektorschaltungen liegenden Transistoren die Basis und/oder der Emitter jeweils an Wirkwiderstände angeschlossen über eine kapazitive Induktivität, deren Windungen in einer Fläche parallel zu einem Massebelag, z. B. auf einem isolierenden Substrat, aufgebracht sind und die so bemessen ist, daß sie an ihrem Eingang eine niedrige kapazitive Impedanz gegen Masse und eine höhere induktive oder auch kapazitive Impedanz gegenüber ihrem mit dem Wirkwiderstand verbundenen Ausgang aufweist. Dadurch kann einerseits die für die Rückkopplung und/oder Abstimmung erforderliche kapazitive Impedanz erhalten und gleichzeitig ein angeschlossenes Gleichstrom-Zuführungsnetzwerk mit Widerständen ausreichend entkoppelt werden.

Nach einer anderen Weiterbildung ist wenigstens ein Wirkwiderstand an den Oszillator angeschlossen über eine, bei der betreffenden Frequenz gegenüber dem Oszillator eine hohe Impedanz aufweisende abgestimmte Leitung, z. B. eine Viertelwellenlängen-Leitung. So kann der Wirkwiderstand, der für die Gleichspannungseinstellung erforderlich ist, von den Mikrowellen-Schwingungen entkoppelt werden.

Nach einer anderen Weiterbildung der Erfindung enthält der Grundschwingungsresonanzkreis eine durch eine Spannung steuerbare Kapazität, und wenigstens eine Leitung zur Zuführung der Abstimmspannung weist eine bei der betreffenden anliegenden Schwingung hohe Impedanz, insbesondere Blindimpedanz, auf. Damit kann der Frequenzbereich bei Frequenzmodulation vergrößert werden dadurch, daß den ohm'schen Widerständen des Netzwerkes der Abstimmgleichspannung niedrigere Werte gegeben werden können, ohne daß dies die Mikrowellen störend dämpft, wobei jedoch die mit der Abstimmkapazität zusammen gebildete Zeitkonstante entsprechend reduziert wird.

Die Erfindung wird nachstehend anhand der Zeichnung beispielsweise näher erläutert, die
in Fig. 1 das bereits erörterte Prinzipschaltbild des zugrundeliegenden Oberschwingungsoszillators und
in Fig. 2 in schematischer Darstellung ein Ausführungsbeispiel der Erfindung zeigt.

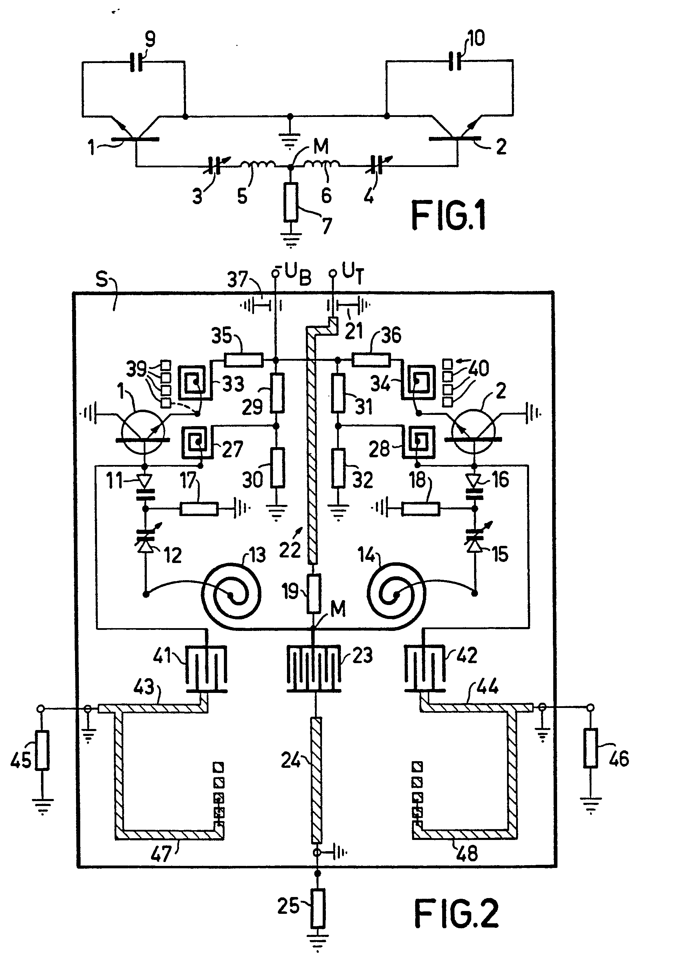

In Fig. 2 ist zwischen den Basen der Transistoren 1 und 2 die Reihenschaltung eines ersten Entkopplungskondensators 11, der als in Sperrichtung vorgespannte Diode ausgeführt ist, einer ersten Abstimmdiode 12, einer ersten Induktivität 13, einer zweiten Induktivität 14, einer zweiten Abstimmdiode 15 und eines zweiten Trennkondensators 16, der ebenfalls als in Sperrichtung vorgespannte Diode ausgeführt ist, eingeschaltet. Der Verbindungspunkt der Dioden 11 und 12 einerseits und 15 und 16 andererseits ist über je einen ersten bzw. zweiten Trennwiderstand 17 und 18 von 3.000 Ohm an Masse angeschlossen. Der Verbindungspunkt M der Induktivitäten 13 und 14 ist über einen Widerstand 19 von 300 Ohm mit einer Steuerspannungsquelle $U_T$ verbunden. Diese liefert eine Gleichspannung zur Abstimmung der Kapazitätsdioden 12 und 15. Sie kann aber auch eine Signalspannung enthalten, mit der eine Frequenzmodulation der erzeugten Oszillatorschwingungen vorgenommen werden soll. Die Abstimmspannung $U_T$ wird über einen an der anderen Seite an Masse liegenden Durchführungskondensator 21 und ein Streifenleitungsstück 22 zugeführt, das auf eine Viertelwellenlänge der Oberschwingung von 2,4 GHz abgestimmt ist. Während sich am Punkt M ein Symmetriepunkt der Grundschwingungen von 1,2 GHz befindet, haben hier die Oberschwingungen eine große Amplitude. Die abgestimmte Leitung 22 liegt am Kondensator 21 wechselspannungsmäßig auf Masse; sie hat daher an ihrem unteren Ende eine maximale Impedanz, so daß über den Wirkwiderstand 19 nur ein minimaler Oberschwingungsstrom fließt.

Die Oberschwingungen vom Punkt M werden über einen interdigitalen Kondensator 23 einer 50 Ohm-Leitung 24 zugeführt, deren unteres Ende mit einem Nutzlastwiderstand 25 von 50 Ohm abgeschlossen ist. Der Oszillator nach Fig. 2 ist auf einer isolierenden Substratplatte S aufgebaut, die aus $Al_2O_3$ oder Teflon o.dgl. bestehen kann mit aufgebrachten leitenden Belägen aus Gold oder Kupfer in Dünnfilmtechnik. Die Unterseite der Platte S ist mit einem Masse-Belag aus Metall versehen. Der durch kammartig ineinandergreifende Beläge gebildete Kondensator 23 wirkt infolgedessen als kapazitives π-Glied, mit dem eine Transformation zwischen dem Punkt M und der Leitung 24 bewirkt wird.

Die Kondensatoren 11 und 16 dienen lediglich dazu, die Gleichstromkreise der Basen und der Abstimmspannung $U_T$ voneinander zu entkoppeln. Es hat sich als zweckmäßig erwiesen, hierfür ebenfalls je eine spannungsabhängige Kapazitätsdiode zu benutzen. Diese kann jedoch höhere Kapazitätswerte aufweisen, deren Änderungen infolge der angelegten Spannung sich auf die Abstimmung des Oszillators nicht merklich auswirken.

Die Basen der Transistoren 1 und 2 sind über je eine flächenhafte Induktivität 27 bzw. 28 mit den Abgriffen von Spannungsteilern 29, 30 bzw. 31, 32 aus Widerständen 29 und 31 von 270 bzw. Widerständen 30 und 32 von 1.200 Ohm verbunden, die zwischen einer Speisespannung $-U_B$ und Masse eingeschaltet sind. Die flächenhaft auf dem Substrat angebrachten Windungen der Spulen 27 und 28 haben gegenüber dem Masse-Belag auch Kapazität. Sie sind jedoch so bemessen, daß an ihrem basisseitigen Eingang eine hohe Impedanz auftritt, so daß die Basen gegenüber den Wirkwiderständen 29 bis 32 ausreichend entkoppelt sind.

Die Emitter der Transistoren 1 und 2 sind über Spulen 33 bzw. 34 und Emitterwiderständen 35 bzw. 36 von 12 Ohm mit der Speisequelle $-U_B$ verbunden, deren Anschluß über einen Durchführungskondensator 37 entkoppelt ist. Die Windungen der Spule 33 haben ebenfalls Kapazität nach Masse, und sie sind so abgestimmt, daß am emitterseitigen Eingang die für die Rückkopplung erforderliche Kapazität (vgl. 9 und 10 in Fig. 1) auftritt und daß für die Grundschwingung und die Oberschwingungen eine induktive Entkopplung gegenüber dem Gleichspannungswiderstand 35 bzw. 36 auftritt. Neben den Spulen 33 und 34 sind Teilbeläge 39 bzw. 40 angebracht. Diese haben gegenüber dem auf der Unterseite des Substrates angebrachten Belag definierte Kapazitätswerte. Wenn man einen oder mehrere dieser Teilbeläge an den Emitter anschließt, kann man die Emitter-Kollektor-Kapazität um kleine Beträge erhöhen, so daß ein etwa erforderlicher Abgleich möglich ist.

Nach der Erfindung ist an die Basiselektrode des Transistors 1 über einen interdigitalen Kondensator 41 als kapazitive Koppelimpedanz und eine Streifenleitung 43 eine Belastungsimpedanz 45 von 50 Ohm angeschlossen, an der ein Teil der Grundschwingung entnommen werden kann, z. B. zur Steuerung eines Frequenzteilers. Die Streifenleitung 43 kann ggf. transformierend wirken. Am Ende der Leitung 43 ist der eine Streifenleitung 47 angeschlossen, die am Ende offen ist und auf die Oberschwingung abgestimmt ist; sie wirkte daher als Saugkreis am Ende der Leitung 43. Am Ende der Leitung 47 sind noch einzelne Leitungselemente dargestellt, die nach Bedarf angeschlossen werden können, um die Leitungslänge auf die erwünschte Resonanz abzustimmen.

Es ist zweckmäßig, an die Basis des Transistors 2 mit einer kapazitiven Impedanz 42, einem Leitungsstück 44, einem Belastungswiderstand 46 und einer Saugkreis-Leitung 48 entsprechende Elemente anzuschließen wie an der Basis des Transistors 1, um die Symmetrie sicherzustellen.

**Patentansprüche**

1. Mikrowellen-Oszillator in Gegentaktschaltung mit zwei Transistoren, bei dem an einem Symmetriepunkt (M) der Grundschwingung die Schwingungen der zweiten Harmonischen (der doppelten Frequenz der Grundschwingung) entnommen werden, dadurch gekennzeichnet, daß an der Basiselektrode wenigstens eines Transistors (1) über eine kapazitive Impedanz (41) ein Teil der Grundschwingungen entnommen wird, wodurch die Belastung des Oszillators für die Grundwelle gering gehalten wird, und eine hohe Oberschwingungsausbeute gewährleistet bleibt.

2. Oszillator nach Anspruch 1, dadurch gekennzeichnet, daß zwischen dem Ausgang des kapazitiven Elementes (41) und Masse ein transformierendes Element (43) eingeschaltet ist.

3. Oszillator nach Anspruch 1 oder 2, dadurch gekennzeichnet, daß zwischen dem Ausgang der kapazitiven Impedanz (41) und Masse ein Reihen-Resonanzkreig (47) für die Harmonischen-Schwingungen (Oberschwingungen) eingeschaltet ist.

4. Oszillator nach einem der vorangehenden Ansprüche, dadurch gekennzeichnet, daß bei in Kollektorschaltung liegen den Transistoren (1, 2) die Basen und/oder die Emitter jeweils an Wirkwiderstände (29-32; 35, 36) angeschlossen sind über wenigstens eine kapazitive Induktivität (33, 34), deren Windungen in einer Fläche parallel zu einem Masse-Belag aufgebracht sind und die so bemessen ist, daß sie eine niedrigere kapazitive Impedanz an ihrem Eingang gegen Masse und eine höhere induktive oder auch kapazitive Impedanz gegenüber ihrem mit einem Wirkwiderstand (35, 36) verbundenen Ausgang aufweist.

5. Oszillator nach einem der vorangehenden Ansprüche, dadurch gekennzeichnet, daß wenigstens ein Wirkwiderstand (45 bzw. 46) angeschlossen ist über eine, bei der betreffenden Frequenz gegenüber dem Oszillator eine hohe Impedanz aufweisende abgestimmte Leitung, z.B eine Viertelwellenlängenleitung (43 bzw. 44).

6. Oszillator nach einem der vorangehenden Ansprüche, dadurch gekennzeichnet, daß am Symmetriepunkt (M) der Grundschwingungen eine Anpassung (23) für die entnommenen Oberschwingungen vorgenommen wird.

7. Oszillator nach einem der vorangehenden Ansprüche, dadurch gekennzeichnet, daß der Grundschwingungs-Resonanzkreis wenigstens eine, durch eine Spannung steuerbare Kapazität (12, 15) enthält, und daß wenigstens eine Leitung (22) zum Zuführen der Abstimmspannung eine bei der bzw. den anliegenden Schwingungen hohe Impedanz aufweist.

8. Oszillator nach Anspruch 7, dadurch gekennzeichnet, daß der Symmetriepunkt (M) der zwischen den Basen angebrachten Impedanzen, dem die Abstimmspannung zugeführt wird, über eine Viertelwellenlängenleitung (22) für die Oberschwingungen mit dem Masse-Punkt, insbesondere an einem Durchführungskondensator (21) nach Masse, verbunden ist.

**Claims**

1. A microwave pushpull oscillator with two transistors, in which the oscillations of the second harmonic (twice the frequency of the fundamental frequency) is taken from a symmetry point (M) of the fundamental frequency, characterized in that a portion of the fundamental frequency is taken from the base electrode of at least one transistor (1) via a capacitive impedance (41), as a result of which the load of the oscillator for the fundamental frequency is kept small and a high harmonic efficiency is ensured.

2. An oscillator as claimed in Claim 1, characterized in that a transformer element (43) is arranged between the output of the capacitive element (41) and ground.

3. An oscillator as claimed in Claim 1 or 2, characterized in that a series resonant circuit (47) for the harmonic oscillations (harmonics) is arranged between the output of the capacitive element (41) and ground.

4. An oscillator as claimed in any of the preceding Claims, characterized in that of collector-grounded transistors (1, 2) the bases and/or the emitters are each connected to active resistors (29-31; 35,36) via at least one capacitive inductance (33, 34), whose windings are arranged in one plane in parallel with a ground coating and which is rated such that it has a lower capacitive impedance at its input with respect to ground and a higher inductance or also capacitive impedance with respect to its output connected to an active resistor (35, 36).

5. An oscillator as claimed in any one of the preceding Claims, characterized in that at least one active resistor (45, 46, respectively) is connected via a tuned circuit which has at the relevant frequency a high impedance with respect to the oscillator, for example a quater-wave line (43 or 44, respectively).

6. An oscillator as claimed in anyone of the preceding Claims, characterized in that at the symmetry point (M) of the fundamental frequency the taken-off higher harmonics are matched (23).

7. An oscillator as claimed in any one of the preceding Claims, characterized in that the fundamental frequency- resonant circuit comprises at least one capacitance (12, 15) which is controllable by a voltage, and that at least one line (22) for conveying the tuning frequency has at the applied oscillation(s) a high impedance.

8. An oscillator as claimed in Claim 7, characterized in that the symmetry point (M) of the impedance arranged between the bases, to which symmetry point the tuning voltage is applied, is connected for the higher harmonics <u>via</u> a quater-wave length line (22) to the ground point, more specifically to a feed-through capacitor (21) to ground.

**Revendications**

1. Oscillateur micro-ondes push-pull à deux transistors dont sont prélevées, en un point de symétrie (M) des oscillations fondamentales, les oscillations du deuxième harmonique (fréquence double des oscillations fondamentales), caractérisé en ce qu'à l'électrode de base d'au moins un transistor (1) une partie des oscillations fondamentales est prélevée par l'intermédiaire d'une impédance capacitive (41), de sorte que la charge de l'oscillateur pour l'onde fondamentale est maintenue faible et qu'un haut rendement en harmoniques reste garanti.

2. Oscillateur suivant la revendication 1, caractérisé en ce qu'un élément transformateur (43) est connecté entre la sortie de l'élément capacitif (41) et la masse.

3. Oscillateur suivant la revendication 1 ou 2, caractérisé en ce qu'un circuit résonnant série (47) pour les oscillations harmoniques (harmoniques) est connecté entre la sortie de l'impédance capacitive (41) et la masse.

4. Oscillateur suivant l'une quelconque des revendications précédentes, caractérisé en ce que pour les transistors (1, 2) connectés par les collecteurs, les bases et/ou les émetteurs sont chaque fois connectés à des résistances effectives (29, 32; 35, 36) par l'intermédiaire d'au moins une inductance capacitive (33, 34), dont les spires sont appliquées à plat parallèlement à un revêtement formant masse, et qui est dimensionnée de manière à présenter, à son entrée, une faible impédance capacitive par rapport à la masse et une impédance inductive ou également capacitive plus élevée par rapport à sa sortie connectée à une résistance effective (35, 36).

5. Oscillateur suivant l'une quelconque des revendications précédentes, caractérisé en ce qu'au moins une résistance effective (45 ou 46) est connectée par l'intermédiaire d'une ligne accordée présentant une haute impédance pour la fréquence en question par rapport à l'oscillateur, par exemple une ligne quart d'onde (43 ou 44).

6. Oscillateur suivant l'une quelconque des revendications précédentes, caractérisé en ce qu'au point de symétrie (M) des oscillations fondamentales est effectuée une adaptation (23) pour compenser les harmoniques prélevés.

7. Oscillateur suivant l'une quelconque des revendications précédentes, caractérisé en ce que le circuit résonnant à oscillation fondamentale contient au moins une capacité pouvant être contrôlée par la tension (12, 15) et qu'au moins une ligne (22), destinée à amener la tension d'accord, présente une haute impédance à l'égard de la ou des oscillations appliquées.

8. Oscillateur suivant la revendication 7, caractérisé en ce que le point de symétrie (M) des impédances prévues entre les bases auxquelles est amenée la tension d'accord est connecté, par l'intermédiaire d'une ligne quart d'onde (22) pour les harmoniques, à un point formant masse, en particulier à un condensateur de passage (21) menant à la masse.

FIG.1

FIG.2